# EUROPEAN PATENT APPLICATION

(11) **EP 4 769 482 A1**
(43) Date of publication of application: **01.07.2026**
(21) Application number: 24856470.0
(22) Date of filing: 21.08.2024
(51) Int. Cl.: H01L 21/288, H01L 21/02

(54) **WAFER SUBSTRATE COMPRISING IMPROVED ADHESION REGION, WAFER SUBSTRATE EQUIPPED WITH PROTECTIVE FILM LAYER, AND PRODUCTION METHOD FOR WAFER SUBSTRATE COMPRISING IMPROVED ADHESION REGION**

(30) Priority: 22.08.2023 JP 2023134560
(71) Applicant: Meltex Inc., Chuo-ku, Tokyo 103-0023 (JP); Mimasu Semiconductor Industry Co., Ltd., Takasaki-shi, Gunma 370-3533 (JP); Mipox Corporation, Kanuma-shi, Tochigi 322-0014 (JP)
(72) Inventor: WATARIGUCHI, Shigeru, Saitama-shi, Saitama 331-0811 (JP); SHIMODA, Takahiro, Saitama-shi, Saitama 331-0811 (JP); GODA, Tatsuya, Saitama-shi, Saitama 331-0811 (JP); SHIBATA, Yasuaki, Saitama-shi, Saitama 331-0811 (JP); ITOI, Yuki, Takasaki-shi, Gunma 370-3521 (JP); YAMAGUCHI, Naohiro, Kanuma-shi, Tochigi 322-0014 (JP)
(74) Representative: Vossius & Partner Patentanwälte Rechtsanwälte mbB
(86) International application number: PCT/JP2024/029583
(87) International publication number: WO 2025/041782

(57) **Abstract**

An object of the present invention is to provide, for example, a wafer with a protective film layer which has improved adhesion of the protective film layer to a wafer substrate that has undergone various surface treatments and prevents the invasion of a solution. In order to attain this object, for example, a wafer substrate including an adhesion improvement region 3 is adopted, the wafer substrate 1a being used by placing a protective film layer for inhibiting solution penetration on the surface, wherein the adhesion improvement region 3 for the protective film layer which enhances the adhesion of the protective film layer is disposed along the outer periphery of the wafer substrate that has undergone various surface treatments.

## Description

### Technical Field

The present invention relates to a wafer substrate comprising an adhesion improvement region for a protective film, a wafer substrate with a protective film layer, and a method for producing a wafer substrate.

### Background Art

Heretofore, wafers have been materials indispensable for semiconductor production, and the resulting electronic devices, parts, and the like have been widely utilized in every electronic or electric product in fields such as automobiles, digital consumer electronics, and communications equipment.

For example, in power semiconductors, an electrode may be placed on the surface of a wafer substrate, and a metal film may be formed throughout the underside. This underside metal film is formed by a method such as vapor deposition or plating. In this context, for example, when the electrode on the wafer substrate surface is plated, a protective membrane such as a protective film is generally attached to the whole underside of the wafer substrate in order to protect the underside metal film of the wafer substrate from a solution such as a plating solution or a washing solution. Nonetheless, an adhesive used in the protective film generally has low adhesion to the metal film, and a phenomenon occurs in which a solution infiltrates into between the protective film and the wafer substrate from the outer peripheral end of the wafer substrate on the periphery of the wafer substrate. If the solution infiltration occurs during the course of plating, the dissolution of the metal film or the deposition of the plating occurs, causing reduction in product yield. This is also responsible for the contamination of solutions or wafers due to the detachment of the deposited plating, or reduction in performance of the plating solution by eluted matter from the film. This is further responsible for the peeling of a resist when the resist is formed on the protected surface.

In order to solve such problems, Patent Literature 1 adopts a method for producing a semiconductor apparatus, comprising applying a curable resin to one of the surfaces of a semiconductor substrate, attaching a film thereto, and then curing the curable resin, whereby erosion by a plating solution is prevented, and the other surface of the semiconductor substrate can be plated.

Patent Literature 2 adopts a method for producing a semiconductor apparatus, comprising attaching a protective film to the underside of a wafer, and further attaching another protective film to the side, whereby the protective membranes are stably attached to and peeled from portions where no plating layer is formed, and abnormal deposition of the plating layer can be prevented.

### Citation List

### Patent Literature

Patent Literature 1: Japanese Patent Laid-Open No. 2010-182807
Patent Literature 2: Japanese Patent Laid-Open No. 2016-152317

### Summary of Invention

### Technical Problem

However, both the inventions disclosed in Patent Literatures 1 and 2 mentioned above involve a film for protecting the principal surface of a wafer, and in addition, for preventing the invasion of a solution, the film is fixed using a curable resin in Patent Literature 1, while a protective tape is also attached to the outer peripheral edge in Patent Literature 2. Hence, these inventions present a problem of increase in cost caused by the introduction of apparatuses for the application and peeling of the curable resin or apparatuses dedicated to the attachment and peeling of the protective tape, and the protective film used. Furthermore, the attachment of the protective tape requires applying a given pressure using a roller and may be considered difficult to cope with due to the risk of breakage if a wafer is thinned.

Accordingly, an object of the present invention is to provide, for example, a wafer substrate with a protective film layer which improves the adhesion of the protective film layer to the wafer substrate that has undergone various surface treatments, without the use of the protective tape as mentioned above, and can prevent the invasion of a chemical solution without the protective tape.

### Solution to Problem

The present inventors have conducted diligent studies to attain the object mentioned above and consequently completed the following invention.

Wafer substrate comprising an adhesion improvement region according to the present application: the wafer substrate comprising an adhesion improvement region according to the present application is a wafer substrate that is used by placing a protective film layer for inhibiting solution penetration on the surface, wherein surface treatments for lamination with titanium, chromium, copper, and an alloy thereof are performed using a metal film, the outermost surface of which is made of a noble metal such as gold or silver, by a method such as vapor deposition, sputtering, or plating; and the adhesion improvement region for the protective film layer which enhances the adhesion of the protective film layer is disposed parallel to the outer peripheral end of the wafer substrate that has undergone various surface treatments.

In the wafer substrate comprising an adhesion improvement region according to the present application, the adhesion improvement region is preferably a region free of at least noble metal components gold, silver, platinum, and palladium among inorganic components used in the surface treatments.

In the wafer substrate comprising an adhesion improvement region according to the present application, more preferably, the adhesion improvement region is free of inorganic components used in the surface treatments, and the wafer surface is exposed.

In the wafer substrate comprising an adhesion improvement region according to the present application, the adhesion improvement region placed parallel to the outer periphery of a planar wafer substrate is preferably a strip-shaped region having a width of 0.2 mm or larger and 3 mm or smaller parallel to the outer periphery of the wafer substrate.

In the wafer substrate comprising an adhesion improvement region according to the present application, the adhesion improvement region placed parallel to the outer peripheral end of a wafer substrate having a strip-shaped projection in a raised shape along the outer periphery is preferably a strip-shaped region having a width of 0.2 mm or larger and W1 mm or smaller from the outer peripheral end of the wafer substrate when the width of the strip-shaped projection is defined as W1 mm.

Wafer substrate with a protective film layer according to the present application: the wafer substrate with a protective film layer according to the present application has an improved effect of inhibiting solution penetration by placing the protective film layer on the surface of the aforementioned wafer substrate comprising an adhesion improvement region.

Method for producing the wafer substrate comprising an adhesion improvement region according to the present application: the method for producing the wafer substrate comprising an adhesion improvement region according to the present application is a method for producing the aforementioned wafer substrate comprising an adhesion improvement region, the method comprising physically polishing or cutting the surface of a variously surface-treated wafer substrate, parallel to the outer peripheral end, and thereby peeling a partial metal layer or the whole metal layer constituting the surface treatment layer located on the outer periphery of the wafer surface to form an adhesion improvement region, the surface treatment layer having been laminated with titanium, chromium, copper, and an alloy thereof using a metal film, the outermost surface of which is made of a noble metal such as gold or silver, by a method such as vapor deposition, sputtering, or plating.

In the method for producing the wafer substrate comprising an adhesion improvement region according to the present application, in the case of placing the adhesion improvement region on the outer periphery of a planar wafer substrate, a strip-shaped region is preferably prepared by physically polishing or cutting a surface portion having a width of 0.2 mm or larger and 3 mm or smaller parallel to the outer peripheral end of the wafer substrate.

In the method for producing the wafer substrate comprising an adhesion improvement region according to the present application, in the case of placing the adhesion improvement region on the outer periphery of a wafer substrate having a strip-shaped projection in a raised shape along the outer periphery, a strip-shaped region is preferably prepared by physically polishing or cutting a surface portion having a width of 0.2 mm or larger and W1 mm or smaller parallel to the outer peripheral end of the wafer substrate when the width of the strip-shaped projection is defined as W1 mm.

In the method for producing the wafer substrate comprising an adhesion improvement region according to the present application, a depth of polish in performing the polishing is preferably 20 nm to 10 µm.

### Advantageous Effects of Invention

According to the present invention, an adhesion improvement region for a protective film layer which enhances the adhesion of the protective film layer is disposed parallel to the outer peripheral end of a wafer substrate that has undergone various surface treatments, whereby the infiltration of a chemical solution into between the underside of a wafer and a protective film can be effectively prevented. The adhesion improvement region placed parallel to the outer peripheral end of the wafer substrate can be easily formed by polishing or cutting, and existing apparatuses can be used for film attachment and film peeling. In addition, excessive capital investment is unnecessary, and high-quality wafer products can be inexpensively provided. The adoption of the invention according to the present application eliminates the need of the attachment of a protective tape to the outer edge heretofore used, and can suppress excessive capital investment and increase in material cost.

### Brief Description of Drawings

[Figure 1] Figure 1 is a three-view drawing schematically showing a planar wafer substrate with an adhesion improvement region.
[Figure 2] Figure 2 is a three-view drawing schematically showing a planar wafer substrate with an adhesion improvement region having a strip-shaped projection in a raised shape along the outer periphery.
[Figure 3] Figure 3 is an image drawing of a processing apparatus for forming an adhesion improvement region by polishing a surface treatment layer located on the outer peripheral edge of a wafer.
[Figure 4] Figure 4 is a schematic view showing a state without the invasion of a solution into between a protective film and a wafer substrate in the case of having an adhesion improvement region (Example), and a state with the invasion of a solution into between a protective film and a wafer substrate in the case of having no adhesion improvement region (Comparative Example).

### Description of Embodiments

Hereinafter, the wafer substrate comprising an adhesion improvement region, the wafer substrate with a protective film, and the method for producing the wafer substrate comprising an adhesion improvement region according to the present invention will be described. The wafer substrate is a substrate formed with a compound semiconductor such as silicon or silicon carbide.

### 1. Embodiment of wafer substrate comprising adhesion improvement region

The wafer substrate comprising an adhesion improvement region according to the present application is used by placing a protective film layer for inhibiting solution penetration on the surface. In general, a wafer substrate is subjected on its surface to various surface treatments upon use thereof. In such surface treatments, inorganic components such as gold, silver, and nickel are widely used in a multilayered state. Thus, a protective film to be laminated with the wafer substrate is laminated via the surface treatment layer. In this state, the protective film has insufficient adhesion. Accordingly, an adhesion improvement region for a protective film layer which enhances the adhesion of the protective film layer is placed parallel to the outer peripheral end of the wafer substrate.

This adhesion improvement region refers to a region from which surface treatment components that inhibit the adhesion of the protective film layer have been removed parallel to the outer peripheral end of the wafer substrate with the formed surface treatment layer. The adhesion improvement region is desirably placed on the basis of the following technical brief.

In the wafer substrate comprising an adhesion improvement region, the adhesion improvement region is preferably a region free of at least noble metal components such as noble metal components gold, silver, platinum, and palladium among inorganic components used in the surface treatments. This is because the noble metal components most destabilize the adhesion of a protective film.

Even if the adhesion improvement region is placed from which the noble metal components have been removed as mentioned above, the adhesion of a protective film on the outer peripheral edge of a wafer may still be insufficient. In such a case, more preferably, the inorganic components used in the surface treatments, present in the outer peripheral region of the wafer substrate are completely removed from the adhesion improvement region to expose the wafer surface of the outer peripheral region. This is because, by completely removing the components used in the surface treatment layer, a protective film reliably obtains adhesion to the wafer substrate and reliably prevents the invasion of a solution.

In this wafer substrate comprising an adhesion improvement region, the adhesion improvement region placed on the outer periphery of a planar wafer substrate is preferably a strip-shaped region having a width of 0.2 mm or larger and 3 mm or smaller parallel to the outer peripheral end of the wafer substrate (hereinafter, this width is simply referred to as an "adhesive width"). If the adhesive width is less than 0.2 mm, the adhesion of a protective film is destabilized so that the invasion of a solution cannot be completely prevented. On the other hand, an adhesive width exceeding 3 mm is not preferable because an improving effect on a protective film is not enhanced.

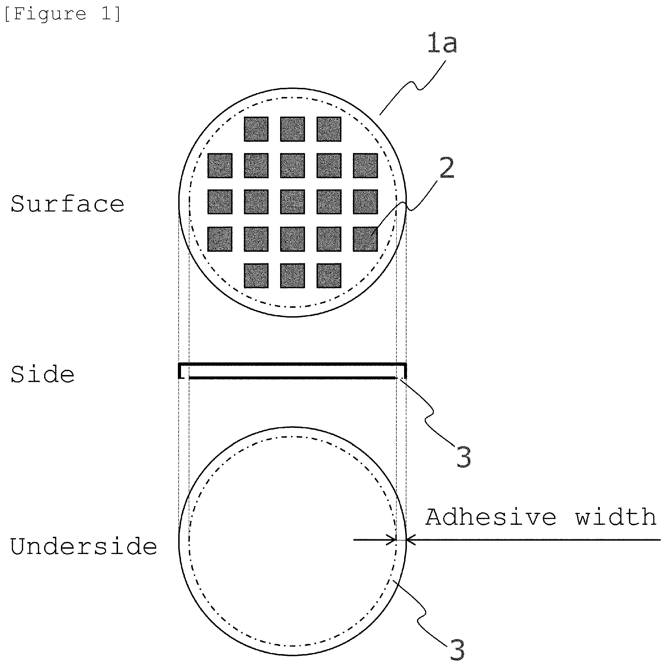

Figure 1 shows a three-view drawing of a planar wafer substrate 1a with an adhesion improvement region. From this Figure 1, it can be understood that an adhesion improvement region 4 for a protective film layer which enhances the adhesion of a protective film layer 3 is disposed parallel to the outer peripheral edge of a silicon wafer substrate 2. The description about a surface treatment layer having a thickness of several tens of nm to several µm is omitted from the three-view drawing shown in Figure 1.

When the wafer substrate comprising an adhesion improvement region is a wafer substrate having a strip-shaped projection in a raised shape along the outer periphery (which means a so-called "TAIKO" shape), the adhesion improvement region is placed as described below. When the width of the strip-shaped projection in a protruding state is defined as W1 mm, a strip-shaped region having a width (adhesive width) of 0.2 mm or larger and W1 mm or smaller parallel to the outer peripheral end of the wafer substrate is preferably used as the adhesion improvement region. An adhesive width of less than 0.2 mm is not preferable because the adhesion of a protective film is destabilized so that the invasion of a solution cannot be completely prevented. On the other hand, an adhesive width exceeding the width W1 mm of the strip-shaped projection in a raised shape along the outer periphery of the wafer substrate is not preferable because the adhesion of a protective film to the wafer substrate is rather destabilized.

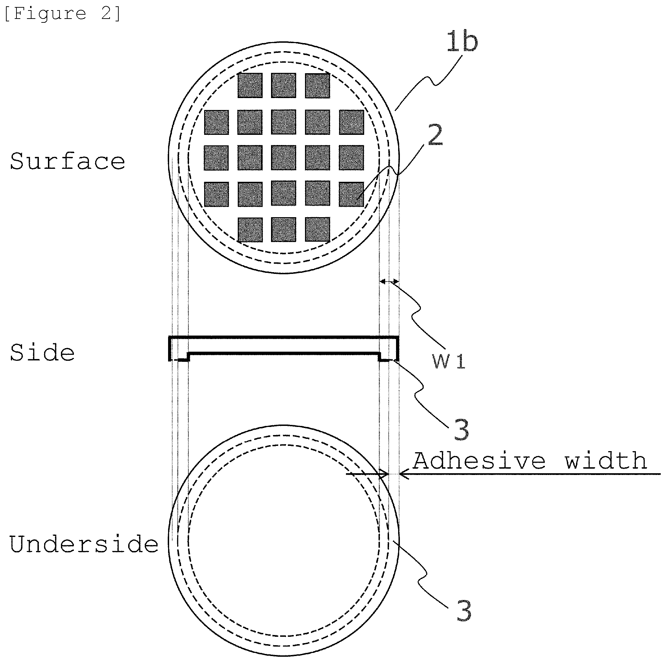

Figure 2 shows a three-view drawing of a wafer substrate 1b with an adhesion improvement region when the wafer substrate is a wafer substrate 1b having a strip-shaped projection in a raised shape along the outer periphery (which means a so-called "TAIKO" shape). From this Figure 2, it can be understood that an adhesion improvement region 4 for a protective film layer which enhances the adhesion of a protective film layer 3 is disposed parallel to the outer peripheral end of a wafer substrate 2. The description about a surface treatment layer having a thickness of several tens of nm to several m is omitted from the three-view drawing shown in Figure 2.

Form of the wafer substrate with a protective film layer: a feature of the wafer substrate with a protective film layer according to the present application is to prevent solution penetration into between the wafer substrate and a protective film by placing the protective film layer on the surface of the aforementioned wafer substrate comprising an adhesion improvement region. In this respect, a known method such as a roller attachment method or a vacuum attachment method may be used for the lamination of the protective film to the wafer substrate.

Form of the method for producing the wafer substrate comprising an adhesion improvement region: the method for producing the wafer substrate comprising an adhesion improvement region according to the present application is a method for producing the aforementioned wafer substrate comprising an adhesion improvement region. Thus, it can be understood from the above description that the wafer substrate comprising an adhesion improvement region which prevents solution penetration into between the wafer substrate and a protective film is produced by controlling surface treatment components present on the surface of the wafer substrate.

Various methods are possible in view of removing the surface treatment layer placed on the surface of a wafer. The possible methods are, for example: (1) in a region serving as the adhesion improvement region, a plating resist is disposed, or the surface treatment layer is not placed in a partial portion so as not to deposit plating by covering with a jig; (2) after surface treatments, the surface treatment layer is removed by wet etching only from an outer peripheral edge region of the wafer substrate; and (3) after surface treatments, the surface treatment layer is removed by dry etching with an argon ion or the like only from an outer peripheral edge region of the wafer substrate. However, all of these methods require excessive cost for capital investment and have low work efficiency.

Accordingly, the present invention involves polishing or cutting the surface of a variously surface-treated wafer substrate, along the outer periphery, and thereby peeling a partial metal layer or the whole metal layer constituting the surface treatment layer located on the outer periphery of the wafer surface to form an adhesion improvement region.

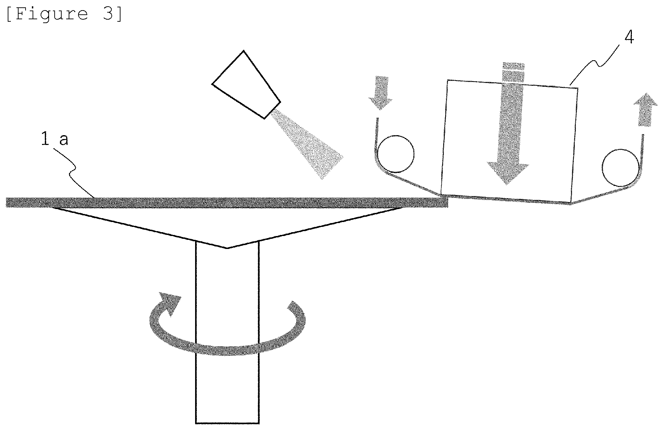

Figure 3 is an image drawing of a processing apparatus for forming an adhesion improvement region by physically polishing or cutting a surface treatment layer located on the outer peripheral edge of a wafer substrate.

In the case of a planar wafer substrate 1a with an adhesion improvement region, by using such an apparatus, an adhesion improvement region 4 which enhances the adhesion of a protective film layer 3, placed on the outer periphery thereof is formed by physically polishing or cutting a strip-shaped region having an adhesive width of 0.2 mm or larger and 3 mm or smaller parallel to the outer peripheral end of a wafer substrate 2. The reason for defining the adhesive width is the same as mentioned above.

In the case of a wafer substrate 1b comprising an adhesion improvement region, which is a wafer substrate 2 having a strip-shaped projection in a raised shape along the outer periphery, when the width of the strip-shaped projection in a protruding state is defined as W1 mm, a strip-shaped region having a width (adhesive width) of 0.2 mm or larger and W1 mm or smaller is preferably formed, by physical polishing or cutting, parallel to the outer peripheral end of the wafer substrate 2 and used as an adhesion improvement region 3 for a protective film layer. The reason for defining the adhesive width is the same as mentioned above.

In the method for producing the wafer substrate comprising an adhesion improvement region according to the present application, the depth of polish or cut in performing the polishing or the cutting is not particularly limited under normal conditions as long as surface treatment components that inhibit the adhesion of a protective film can be removed. However, the depth is practically preferably 20 nm to 10 µm. A depth of polish or cut of less than 20 nm is not preferable because metal components that inhibit the adhesion of a protective film remain. A depth of polish or cut exceeding 10 µm is not preferable either because the wafer surface is exposed so that the adhesion of a protective film is no longer improved.

The wafer substrate comprising an adhesion improvement region according to the present application may also be utilized in various methods for protecting the underside of a wafer, such as a protection method using a protective tape for a single-sided adhesive layer, or a method for protecting a wafer with a glass wafer using a double-faced tape.

The mode for carrying out the present invention described above is an aspect of the present invention and can be appropriately changed or modified without departing from the gist of the present invention. The present invention will be more specifically described with reference to Examples given below. However, the present invention is not limited by the following Examples.

### Example 1

A silicon wafer substrate of 8 inches in diameter with a surface treatment layer already formed was provided. In this respect, the surface treatment layer was a titanium/nickel/gold multilayered plating layer (outermost layer: gold) formed by sputtering. This was applied to a polishing apparatus shown in Figure 3, and the outer peripheral edge was polished so that only the gold layer as the outermost layer was removed to obtain a silicon wafer substrate with an adhesion improvement region.

A protective film was laminated to the underside of this silicon wafer substrate with an adhesion improvement region by two types of methods (roller attachment method and vacuum attachment method) to obtain a silicon wafer substrate with the protective film. This silicon wafer substrate with the protective film was subjected to a solution penetration test. The test process is shown in Table 1. The results are shown in Table 2 such that the results were able to be compared with those of Comparative Example.

**[Table 1]**

| | Conditions (1-minute washing with water was carried out between steps) | | |
|---|---|---|---|
| Step | Liquid nature | Bath temperature | Treatment time |
| Cleaning | pH 10 | 70°C | 30 sec |
| Etching | pH 10 | 70°C | 30 sec |
| Conditioning | Acidic | RT | 20 sec |
| First zinc substitution | Strongly alkaline | RT | 20 sec |
| Zinc peeling | Strongly acidic | RT | 20 sec |
| Second zinc substitution | Strongly alkaline | RT | 30 sec |
| Electroless nickel plating | pH 4.6 | 85°C | 20 min |
| Electroless gold plating | pH 7.0 | 80°C | 20 min |

### Example 2

A silicon wafer substrate of 8 inches in diameter with a surface treatment layer already formed was provided in the same manner as in Example 1. In this respect, the surface treatment layer was a titanium/nickel/gold multilayered plating layer (outermost layer: gold) formed by sputtering. This was applied to a polishing apparatus shown in Figure 3, and the outer peripheral edge was polished so that the surface treatment layer was completely removed to obtain a silicon wafer substrate with an adhesion improvement region.

A protective film was laminated to the underside of this silicon wafer substrate with an adhesion improvement region by two types of methods (roller attachment method and vacuum attachment method) to obtain a silicon wafer substrate with the protective film. This silicon wafer substrate with the protective film was subjected to a solution penetration test. The test process is shown in Table 1. The results are shown in Table 2 such that the results were able to be compared with those of Comparative Example.

### Example 3

A silicon wafer substrate of 8 inches in diameter having a strip-shaped projection in a raised shape along the outer periphery with a surface treatment layer already formed was provided. In this respect, the surface treatment layer was a titanium/nickel/gold multilayered plating layer (outermost layer: gold) formed by sputtering. This was applied to a polishing apparatus shown in Figure 3, and the outer peripheral edge was polished so that only the gold layer as the outermost layer was removed to obtain a silicon wafer substrate having a strip-shaped projection in a raised shape with an adhesion improvement region.

A protective film was laminated to the underside of this silicon wafer substrate with an adhesion improvement region by two types of methods (roller attachment method and vacuum attachment method) to obtain a silicon wafer substrate with the protective film. This silicon wafer substrate with the protective film was subjected to a solution penetration test. The test process is shown in Table 1. The results are shown in Table 2 such that the results were able to be compared with those of Comparative Example.

### Example 4

A silicon wafer substrate of 8 inches in diameter having a strip-shaped projection in a raised shape along the outer periphery with a surface treatment layer already formed was provided. In this respect, the surface treatment layer was a titanium/nickel/gold multilayered plating layer (outermost layer: gold) formed by sputtering. This was applied to a polishing apparatus shown in Figure 3, and the outer peripheral edge was polished so that the surface treatment layer was completely removed to obtain a silicon wafer substrate having a strip-shaped projection in a raised shape with an adhesion improvement region.

A protective film was laminated to the underside of this silicon wafer substrate with an adhesion improvement region by two types of methods (roller attachment method and vacuum attachment method) to obtain a silicon wafer substrate with the protective film. This silicon wafer substrate with the protective film was subjected to a solution penetration test. The test process is shown in Table 1. The results are shown in Table 2 such that the results were able to be compared with those of Comparative Example.

### Comparative Example

In this Comparative Example, a silicon wafer substrate of 8 inches in diameter with a surface treatment layer already formed was provided in the same manner as in Example 1. In this respect, the surface treatment layer was a titanium/nickel/gold multilayered plating layer (outermost layer: gold) formed by sputtering, and a silicon wafer substrate with the surface treatment layer remaining was obtained without forming an adhesion improvement region.

A protective film was laminated to the underside of this silicon wafer substrate by two types of methods (roller attachment method and vacuum attachment method) to obtain a silicon wafer substrate with the protective film. This silicon wafer substrate with the protective film was subjected to a solution penetration test. The test process is shown in Table 1. The results are shown in Table 2 such that the results were able to be compared with those of Examples.

### [Evaluation]

Hereinafter, results of comparing Examples 1 to 4 with Comparative Example will be shown. The evaluation results are summarized in Table 2.

**[Table 2]**

| | Protective film attachment method | Presence or absence of polishing | Results | The number of damaged parts in wafer |
|---|---|---|---|---|
| Example 1 | Roller attachment method | Present | No infiltration found | 0 |
| | Vacuum attachment method | | | |
| Example 2 | Roller attachment method | Present | No infiltration found | 0 |
| | Vacuum attachment method | | | |
| Example 3 | Roller attachment method | Present | No infiltration found | 0 |
| | Vacuum attachment method | | | |
| Example 4 | Roller attachment method | Present | No infiltration found | 0 |
| | Vacuum attachment method | | | |
| Comparative Example | Roller attachment method | Absent | Infiltration found | 1 |
| | Vacuum attachment method | | | |

From this Table 2, it is evident that in the case of Examples 1 to 4 having the adhesion improvement region, the invasion of a solution did not occur between the protective film and the silicon wafer substrate. By contrast, it can be understood that in the case of Comparative Example, the invasion of a solution occurred between the protective film and the silicon wafer substrate. There seems no difference between different lamination methods for the protective film.

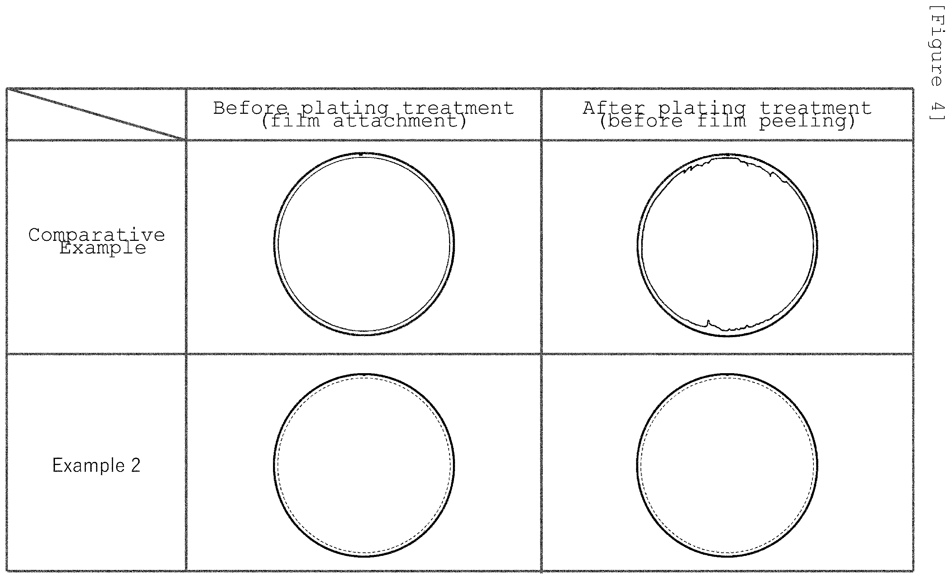

From the number of damaged parts in the wafer shown in Table 2 and the schematic view of Figure 4, a state without the invasion of a solution into between the protective film and the silicon wafer substrate can be understood in the case of Examples 1 to 4 having the adhesion improvement region. By contrast, in the case of Comparative Example, it can be understood that the invasion of a solution occurred between the protective film and the silicon wafer substrate, causing a marked defect.

### Industrial Applicability

High-quality wafer products can be inexpensively provided by using the present invention. As a result, high-quality products using wafers, such as power semiconductors, can be provided for a fair price. The production method adopted by the present application is also advantageous in that excessive capital investment is unnecessary.

### Reference Signs List

1a and 1b: wafer substrate with an adhesion improvement region
2: semiconductor device
3: adhesion improvement region
4: rotary belt-type polishing machine

## Claims

1. A wafer substrate comprising an adhesion improvement region, the wafer substrate being used by placing a protective film layer for inhibiting solution penetration on the surface, wherein
the adhesion improvement region for the protective film layer which enhances the adhesion of the protective film layer is disposed parallel to the outer periphery of the wafer substrate that has undergone various surface treatments.

2. The wafer substrate comprising an adhesion improvement region according to claim 1, wherein the adhesion improvement region is a region free of at least noble metal components gold, silver, platinum, and palladium among inorganic components used in the surface treatments.

3. The wafer substrate comprising an adhesion improvement region according to claim 1, wherein the adhesion improvement region is free of inorganic components used in the surface treatments, and the wafer surface is exposed.

4. The wafer substrate comprising an adhesion improvement region according to claim 1, wherein the adhesion improvement region placed on the outer periphery of a planar wafer substrate is a strip-shaped region having a width of 0.2 mm or larger and 3 mm or smaller parallel to the outer periphery of the wafer substrate.

5. The wafer substrate comprising an adhesion improvement region according to claim 1, wherein the adhesion improvement region placed on the outer periphery of a wafer substrate having a strip-shaped projection in a raised shape along the outer periphery is a strip-shaped region having a width of 0.2 mm or larger and W1 mm or smaller parallel to the outer periphery of the wafer substrate when the width of the strip-shaped projection is defined as W1 mm.

6. A wafer substrate with a protective film layer having an improved effect of inhibiting solution penetration by placing the protective film layer on the surface of a wafer substrate comprising an adhesion improvement region according to any one of claims 1 to 5.

7. A method for producing a wafer having an adhesion improvement region, the method being a method for producing a wafer substrate comprising an adhesion improvement region according to any one of claims 1 to 5, the method comprising
cutting or polishing the surface of a variously surface-treated wafer, parallel to the outer periphery, and thereby peeling a partial metal layer or the whole metal layer constituting the surface treatment layer located in the vicinity of the outer periphery of the wafer surface to form an adhesion improvement region.

8. The method for producing a wafer having an adhesion improvement region according to claim 7, wherein in the case of placing the adhesion improvement region on the outer periphery of a planar wafer substrate, a strip-shaped region is prepared by cutting or polishing a width of 0.2 mm or larger and 3 mm or smaller parallel to the outer periphery of the wafer substrate.

9. The method for producing a wafer having an adhesion improvement region according to claim 7, wherein in the case of placing the adhesion improvement region on the outer periphery of a wafer substrate having a strip-shaped projection in a raised shape along the outer periphery, a strip-shaped region is prepared by cutting or polishing a width of 0.2 mm or larger and W1 mm or smaller parallel to the outer periphery of the wafer substrate when the width of the strip-shaped projection is defined as W1 mm.

10. The method for producing a wafer having an adhesion improvement region according to any one of claims 7 to 9, wherein a depth of cut in performing the cutting or the polishing is 20 nm to 10 µm.
